# EUROPEAN PATENT APPLICATION

(11) **EP 4 472 015 A1**
(43) Date of publication of application: **04.12.2024**
(21) Application number: 23889092.5
(22) Date of filing: 06.11.2023
(51) Int. Cl.: H02J 7/00, G01R 31/3835, G01R 31/389, H01M 10/052, H01M 10/44

(54) **APPARATUS AND METHOD FOR CONTROLLING QUICK CHARGING**

(30) Priority: 08.11.2022 KR 20220148250
(71) Applicant: LG Energy Solution, Ltd., Seoul 07335 (KR)
(72) Inventor: LEE, Ji-Eun, Daejeon 34122 (KR); AN, Ji-Su, Daejeon 34122 (KR); YU, Hye-In, Daejeon 34122 (KR); WHANG, Tae-Kyung, Daejeon 34122 (KR)
(74) Representative: Goddar, Heinz J.
(86) International application number: PCT/KR2023/017701
(87) International publication number: WO 2024/101832

(57) **Abstract**

A rapid charging control apparatus according to an embodiment of the present disclosure includes a measuring unit configured to measure a voltage of a battery; and a control unit configured to estimate a SOC of the battery based on the voltage of the battery, determine a charging C-RATE corresponding to the estimated SOC based on a charging profile preset to represent the corresponding relationship between SOC and charging C-RATE, and block charging of the battery for a predetermined time when the charging C-RATE corresponding to the estimated SOC changes.

## Description

### TECHNICAL FIELD

The present application claims priority to Korean Patent Application No. 10-2022-0148250 filed on November 8, 2022 in the Republic of Korea, the disclosures of which are incorporated herein by reference.

The present disclosure relates to a rapid charging control apparatus and method, and more particularly, to a rapid charging control apparatus and method for efficiently performing rapid charging for a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

As power driving devices such as electric vehicles, electric motorcycles, and electric bicycles are commercialized, the demand for high-capacity and high-performance batteries is increasing. However, as the capacity of the battery increases, the time required to charge the battery also increases. To solve this problem, technology for rapid charging of the battery is being developed, but there are concerns that rapid charging may accelerate battery deterioration.

In particular, during the rapid charging process of the battery, a phenomenon in which lithium is precipitated on the surface of the negative electrode (lithium plating, Li-plating) may occur. When lithium is precipitated on the surface of the negative electrode, it causes side reactions with the electrolyte and changes in the kinetic balance of the battery, resulting in battery deterioration. In addition, as lithium metal is precipitated on the surface of the negative electrode, an internal short circuit of the battery may occur, so there is a risk of ignition or explosion due to an internal short circuit. Therefore, there is a need to develop technology that can prevent lithium metal from precipitating on the surface of the negative electrode and enable rapid charging of the battery.

### DISCLOSURE

### Technical Problem

The present disclosure is designed to solve the problems of the related art, and therefore the present disclosure is directed to providing a rapid charging control apparatus and method for efficiently performing rapid charging for a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A rapid charging control apparatus according to one aspect of the present disclosure may comprise a measuring unit configured to measure a voltage of a battery; and a control unit configured to estimate a SOC of the battery based on the voltage of the battery, determine a charging C-RATE corresponding to the estimated SOC based on a charging profile preset to represent the corresponding relationship between SOC and charging C-RATE, and block charging of the battery for a predetermined time when the charging C-RATE corresponding to the estimated SOC changes.

The charging profile may be configured to include a plurality of SOC sections where a corresponding charging C-RATE is set.

When the estimated SOC reaches an upper limit of a current SOC section to which the estimated SOC belongs as the estimated SOC increases, the control unit may be configured to block charging of the battery for the predetermined time and change the charging C-RATE for the battery to a charging C-RATE corresponding to the next SOC section.

The control unit may be configured to resume charging the battery at the changed charging C-RATE after the predetermined time has elapsed.

The charging C-RATE may be set to decrease when the SOC section to which the estimated SOC belongs changes as the estimated SOC increases.

The control unit may be configured to calculate a resistance value of the battery based on the voltage change during the predetermined time and diagnose a state of the battery according to the calculated resistance value.

The control unit may be configured to calculate the resistance value whenever charging of the battery is blocked for the predetermined time in a plurality of charging cycles, and diagnose the state of the battery by comparing resistance values with the same corresponding charging C-RATE.

The control unit may be configured to diagnose that lithium metal is precipitated in the battery based on resistance values calculated in successive charging cycles among the resistance values with the same corresponding charging C-RATE.

The control unit may be configured to calculate a resistance change rate of the resistance value with respect to a BOL resistance value calculated in a first charging cycle of the battery, and diagnose that lithium metal is precipitated in the battery when a difference between the resistance change rates calculated in the successive charging cycles is greater than or equal to a preset threshold value.

The control unit may be configured to diagnose that lithium metal is precipitated in the battery when a ratio of the resistance difference to the BOL resistance value calculated in the first charging cycle of the battery is greater than or equal to a preset threshold value.

The charging profile may be set to represent the corresponding relationship between the charging C-RATE and SOC corresponding to a maximum point or an inflection point of a resistance profile preset to correspond to the charging C-RATE.

The resistance profile may be set to represent the corresponding relationship between a resistance value corresponding to the charging C-RATE and the SOC.

When the maximum point exists in the resistance profile, the charging profile may be set so that the SOC corresponding to the maximum point corresponds to the charging C-RATE.

When the maximum point does not exist in the resistance profile and the inflection point exists, the charging profile may be set so that the SOC corresponding to the inflection point corresponds to the charging C-RATE.

The charging profile may be configured so that the SOC corresponding to the charging C-RATE increases as the charging C-RATE decreases.

A battery pack according to another aspect of the present disclosure may comprise the rapid charging control apparatus according to one aspect of the present disclosure.

A rapid charging control method according to still another aspect of the present disclosure may comprise: a voltage measuring step of measuring a voltage of a battery; a SOC estimating step of estimating a SOC of the battery based on the voltage of the battery; a charging C-RATE determining step of determining a charging C-RATE corresponding to the estimated SOC based on a charging profile preset to represent the corresponding relationship between SOC and charging C-RATE; and a charging blocking step of blocking charging of the battery for a predetermined time when the charging C-RATE corresponding to the estimated SOC changes.

A rapid charging control method according to still another aspect of the present disclosure may further comprise: a resistance value calculating step of calculating a resistance value of the battery based on the voltage change during the predetermined time, after the charging blocking step; and a battery diagnosing step of diagnosing a state of the battery according to the calculated resistance value.

### Advantageous Effects

According to one aspect of the present disclosure, rapid charging of the battery may be controlled according to the charging profile set to prevent lithium metal from precipitation in the battery during the rapid charging process. Therefore, precipitation of lithium metal during the rapid charging process may be effectively prevented.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a rapid charging control apparatus according to an embodiment of the present disclosure.
FIG. 2 is a diagram schematically showing a charging profile according to an embodiment of the present disclosure.
FIG. 3 is a diagram schematically showing a battery charging process according to an embodiment of the present disclosure.
FIG. 4 is a diagram schematically showing a resistance change rate of a first battery and a second battery according to an embodiment of the present disclosure.
FIG. 5 is a diagram schematically showing a resistance change rate of a third battery and a fourth battery according to an embodiment of the present disclosure.
FIG. 6 is a diagram schematically showing a first resistance profile according to an embodiment of the present disclosure.
FIG. 7 is a diagram schematically showing a first differential profile of the first resistance profile according to an embodiment of the present disclosure.
FIG. 8 is a diagram schematically showing a second resistance profile according to an embodiment of the present disclosure.
FIG. 9 is a diagram schematically showing a first differential profile of the second resistance profile according to an embodiment of the present disclosure.
FIG. 10 is a diagram schematically showing a second differential profile of the second resistance profile according to an embodiment of the present disclosure.
FIG. 11 is a diagram schematically showing a plurality of resistance profiles according to an embodiment of the present disclosure.
FIG. 12 is a diagram schematically showing an exemplary configuration of a battery pack according to another embodiment of the present disclosure.
FIG. 13 is a diagram schematically showing an exemplary configuration of a vehicle according to still another embodiment of the present disclosure.
FIG. 14 is a diagram schematically showing an exemplary configuration of an energy storage system according to still another embodiment of the present disclosure.
FIGS. 15 and 16 are diagrams schematically showing a rapid charging control method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

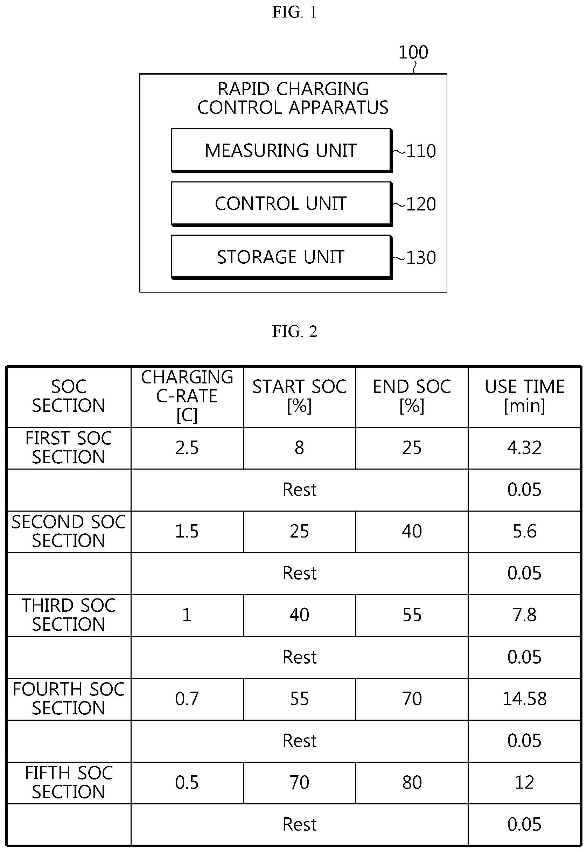

FIG. 1 is a diagram schematically illustrating a rapid charging control apparatus 100 according to an embodiment of the present disclosure.

Here, the battery refers to an independent cell that has a negative electrode terminal and a positive electrode terminal and is physically separable. As an example, a lithium-ion cell or a lithium polymer cell may be considered a battery. Additionally, the battery may mean a battery module in which a plurality of cells are connected in series and/or parallel. Hereinafter, for convenience of explanation, the battery is explained as meaning one independent cell.

Referring to FIG. 1, the rapid charging control apparatus 100 may include a measuring unit 110 and a control unit 120.

The measuring unit 110 may be configured to measure the voltage of the battery.

Specifically, the measuring unit 110 may be connected to the positive electrode terminal and the negative electrode terminal of the battery. Additionally, the measuring unit 110 may be configured to measure the voltage of the battery by measuring the positive electrode voltage and the negative electrode voltage of the battery. For example, the measuring unit 110 may measure the voltage of the battery according to a preset voltage measurement cycle.

The measuring unit 110 may be connected to communicate with the control unit 120. For example, the measuring unit 110 may be connected to the control unit 120 wired and/or wirelessly. Additionally, the measuring unit 110 may transmit information about the measured voltage of the battery to the control unit 120.

The control unit 120 may be configured to estimate the SOC (state of charge) of the battery based on the voltage of the battery.

Specifically, the control unit 120 may receive the voltage of the battery from the measuring unit 110 and estimate the SOC of the battery from the received voltage. Preferably, the voltage and SOC of the battery may be set in advance according to their corresponding relationship. For example, a SOC profile representing the corresponding relationship between voltage and SOC may be prepared in advance. The control unit 120 may determine the SOC corresponding to the voltage received from the measuring unit 110 in the SOC profile, and estimate the determined SOC as the SOC of the battery.

Here, SOC represents the charging state of the battery, and may be preset so that the voltage of the battery corresponds to the SOC. This SOC may be expressed as a value of 0% to 100% or 0 to 1. Hereinafter, for convenience of explanation, SOC is described as having a value of 0% to 100%.

The control unit 120 may be configured to determine the charging C-RATE corresponding to the estimated SOC, based on a charging profile preset to represent the corresponding relationship between SOC and charging C-RATE (Current rate).

Here, the charging profile may be preset to represent the corresponding relationship between SOC and charging C-RATE. The charging C-RATE is a C-RATE at which the battery is charged, and the charging C-RATE for the battery may be determined depending on the SOC of the battery.

Specifically, the corresponding charging C-RATE for a predetermined SOC section may be set in advance. Additionally, the control unit 120 may determine the SOC section to which the current SOC of the battery belongs from the charging profile and determine the charging C-RATE corresponding to the determined SOC section.

FIG. 2 is a diagram schematically showing a charging profile according to an embodiment of the present disclosure. Specifically, the charging profile may be configured to include a plurality of SOC sections where a corresponding charging C-RATE is set.

In the embodiment of FIG. 2, it is assumed that charging of the battery is performed from SOC 8% to 80%. The charging profile may include a first SOC section with SOC 8% to 25%, a second SOC section with SOC 25% to 40%, a third SOC section with SOC 40% to 55%, a fourth SOC section with SOC 55% to 70%, and a fifth SOC section with SOC 70% to 80%. Additionally, a rest period (Rest) of 3 seconds (0.05 minutes) may be included between the SOC sections, respectively.

In the embodiment of FIG. 2, if the SOC of the battery is estimated to be 20%, the SOC of the battery may be included in the first SOC section. Therefore, the control unit 120 may determine the charging C-RATE for the battery to be 2.5 C.

The control unit 120 may be configured to block charging of the battery for a predetermined time when the charging C-RATE corresponding to the estimated SOC changes.

Specifically, whenever the control unit 120 estimates the SOC of the battery, the control unit 120 may determine the charging C-RATE corresponding to the estimated SOC based on the charging profile. For example, the control unit 120 may estimate the SOC each time the control unit 120 receives the voltage of the battery from the measuring unit 110, and determine the charging C-RATE based on the estimated SOC. If the charging C-RATE corresponding to the estimated SOC changes, the control unit 120 may block battery charging for a predetermined time.

Preferably, the charging C-RATE may be set to decrease when the SOC section to which the estimated SOC belongs changes as the estimated SOC increases. In the embodiment of FIG. 2, the size of the corresponding charging C-RATE may decrease in the following order: the first SOC section, the second SOC section, the third SOC section, the fourth SOC section, and the fifth SOC section. In other words, as the SOC of the battery increases (i.e., as the battery is charged), the charging C-RATE for the battery may decrease.

Specifically, when the estimated SOC reaches the upper limit of the current SOC section to which the estimated SOC belongs as the estimated SOC increases, the control unit 120 may be configured to block battery charging for a predetermined time and change the charging C-RATE for the battery to a charging C-RATE corresponding to the next SOC section.

For example, in the embodiment of FIG. 2, assume that the SOC of the battery is estimated to be 20% at time point t1. The control unit 120 may determine the charging C-RATE of the battery at the time point t1 to be 2.5 C. Thereafter, if the SOC of the battery at time point t2 is estimated to be 25%, the control unit 120 may determine that the SOC of the battery at the time point t2 has reached the upper limit of the first SOC section. The control unit 120 may block charging of the battery for a predetermined time at the time point t2 and change the charging C-RATE for the battery to 1.5 C corresponding to the second SOC section.

Here, the predetermined time refers to a charging interruption time set to calculate the charge transfer resistance based on the voltage drop immediately after battery charging is stopped. For example, the predetermined time may be set to any value between 0.1 and 3 seconds.

After a predetermined time has elapsed, the control unit 120 may be configured to resume charging the battery at the changed charging C-RATE.

Specifically, for a new SOC section to which the SOC of the battery belongs, the battery may be charged at the changed charging C-RATE.

For example, in the previous embodiment, assume that the charging C-RATE for the battery is changed to 1.5 C. The control unit 120 may control the battery to be charged at a charging C-RATE of 1.5 C until the SOC of the battery reaches the upper limit (40%) of the second SOC section.

For example, when the battery is charged from SOC 8% to 80% according to the embodiment of FIG. 2, the total charging time for the battery may take 44.55 minutes (i.e., 44 minutes 33 seconds).

The rapid charging control apparatus 100 according to an embodiment of the present disclosure may perform rapid charging for the battery by changing the charging C-RATE for each SOC section. In particular, the rapid charging control apparatus 100 may control the rapid charging of the battery to have a rest period for a predetermined time whenever the charging C-RATE is changed during the rapid charging process.

Meanwhile, the control unit 120 included in the rapid charging control apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the rapid charging control apparatus 100 may further include a storage unit 130. The storage unit 130 may store data necessary for operation and function of each component of the rapid charging control apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

The control unit 120 may be configured to calculate the resistance value of the battery based on the voltage change during a predetermined time.

Specifically, the control unit 120 may calculate the resistance value of the battery based on the voltage change of the battery during the time when charging of the battery is blocked. Preferably, the control unit 120 may be configured to calculate the resistance value whenever charging of the battery is blocked for a predetermined time in the plurality of charging cycles.

The control unit 120 may calculate the resistance value of the battery based on the charging current and voltage at the time point just before the battery charging is blocked and the voltage at the time point after a predetermined time has elapsed after the battery charging is blocked, by using Ohms' law.

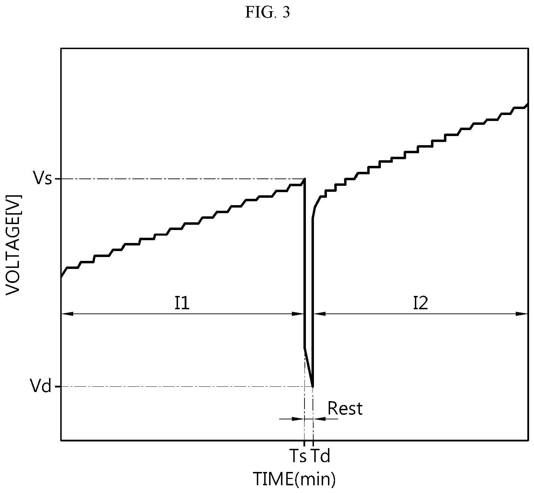

FIG. 3 is a diagram schematically showing a battery charging process according to an embodiment of the present disclosure. For example, assume that the battery is charged with I1 current until the time point Ts, charging of the battery is stopped from the time point Ts to the time point Td, and the battery is charged with I2 current from the time point Td. The battery voltage at the time point Ts may be Vs [V], and the battery voltage at the time point Td may be Vd [V]. In other words, during the rest period (Rest) when battery charging is blocked, the battery voltage may decrease from Vs [V] to Vd [V]. The control unit 120 may calculate the resistance value of the battery by calculating the formula "(Vs - Vd) ÷ I1".

Additionally, the control unit 120 may be configured to diagnose the state of the battery according to the calculated resistance value.

Preferably, the control unit 120 may be configured to diagnose the state of the battery by comparing resistance values with the same charging C-RATE. For example, in the embodiment of FIG. 2, the battery may have a total of 5 rest periods (Rest) in the process of charging from SOC 8% to 80%. Since the SOC of the battery corresponding to each rest period is different, the state of the battery may be diagnosed by comparing resistance values with the same charging C-RATE.

Generally, excessively rapid charging may result in lithium plating, where lithium metal precipitates on the surface of the negative electrode of the battery. Therefore, the control unit 120 may diagnose the state of the battery (in particular, lithium precipitation) based on the rest period resistance value during the rapid charging process. In other words, the control unit 120 may diagnose the state of the battery in real time during rapid charging of the battery.

Specifically, the control unit 120 may be configured to diagnose that lithium metal is precipitated in the battery based on resistance values calculated in successive charging cycles among the resistance values with the same corresponding charging C-RATE.

For example, the control unit 120 may diagnose the state of the battery based on the difference in resistance change rate or the resistance difference with respect to the resistance value of the successive charging cycles.

Here, the difference in resistance change rate may mean the ratio of the calculated resistance value of the battery to the BOL (Beginning of life) resistance value calculated in the first charging cycle of the battery. For example, if the BOL resistance value is R0 and the calculated resistance value of the battery is Rn, the resistance change rate may be expressed according to the formula "(R0 - Rn) ÷ Rn × 100" or "(R0 - Rn) ÷ Rn". The resistance change rate of the resistance value (R1) of the battery calculated at the time point t1 may be calculated as "(R1 - R0) ÷ Rn × 100", and the resistance change rate of the resistance value (R2) of the battery calculated at the time point t2 (time point successive to the time point 11) may be calculated as "(R2 - R0) ÷ Rn × 100", and the difference in resistance change rate may be calculated as "(R1 - R2) ÷ Rn × 100".

Also, the resistance difference may mean the difference between resistance values in successive charging cycles. For example, if the resistance value of the battery calculated at the time point t1 is R1 and the resistance value of the battery calculated at the time point t2 (time point successive to the time point 11) is R2, the resistance difference may be calculated as "R1 - R2".

In one embodiment, the control unit 120 may be configured to calculate a resistance change rate of the resistance value with respect to the BOL resistance value calculated in the first charging cycle of the battery. Additionally, the control unit 120 may be configured to diagnose that lithium metal is precipitated in the battery if the difference in resistance change rates calculated in the successive charging cycles is greater than or equal to a preset threshold value.

In other words, if the resistance change rate calculated in the successive charging cycle decreases by the threshold value or more, the control unit 120 may diagnose the state of the battery as an abnormal state in which lithium metal is precipitated.

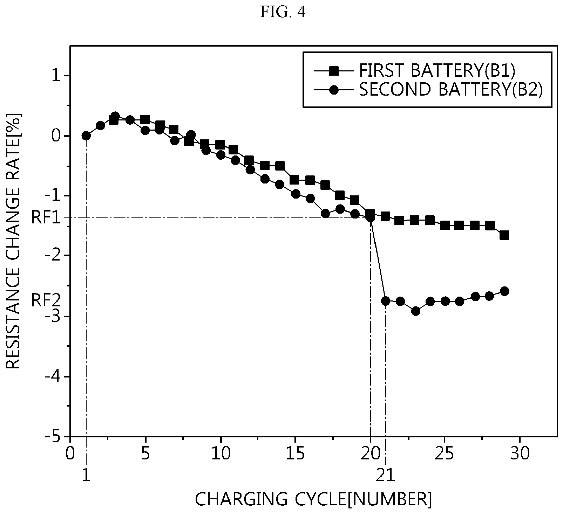

FIG. 4 is a diagram schematically showing a resistance change rate of a first battery B1 and a second battery B2 according to an embodiment of the present disclosure. Specifically, the first battery B1 is a normal battery in which lithium metal has not been precipitated, and the second battery B2 is a defective battery in which lithium metal has been precipitated from the 21 st charging cycle. For example, the first battery B1 and the second battery B2 are the same kind of battery, but in order to determine the change in resistance change rate when lithium metal is precipitated, lithium metal is precipitated on the negative electrode of the second battery B2 from the 21st charging cycle.

Also, the embodiment of FIG. 4 shows the 1 second resistance change rate of the first battery B1 and the second battery B2. In other words, the time during which charging of the first battery B1 and the second battery B2 is blocked is set to 1 second, the resistance value of the first battery B1 and the second battery B2 is calculated based on the voltage change for 1 second, and the resistance change rate is calculated based on the calculated resistance value.

The resistance change rate in the 20th charging cycle of the second battery B2 may be RF1%, and the resistance change rate in the 21st charging cycle may be RF2%. Here, the control unit 120 may calculate the difference in resistance change rate between the 20th charging cycle and the 21st charging cycle as "RF1 - RF2". Additionally, the control unit 120 may compare the difference in the calculated resistance change rate with a preset threshold value.

Here, the threshold value may be set to a value that may indicate a rapid change in the resistance change rate of the successive charging cycle. Specifically, the threshold value may be preset to a value of 0.5% or more, for example, based on the type of battery, the use of the battery, etc. Preferably, the threshold value may be preset to a value of 1% or more. Below, it is assumed that the threshold value is set to 1%.

In the embodiment of FIG. 4, the difference in resistance change rate corresponding to the successive charging cycle of the first battery B1 is not greater than the threshold value (1%). Therefore, the control unit 120 may diagnose the first battery B1 as a normal battery in which lithium metal is not precipitated. On the other hand, because the difference (RF1 - RF2) in resistance change rate of the second battery B2 between the 20th and 21st charging cycles is greater than the threshold value (1%), the control unit 120 may diagnose the second battery B2 as an abnormal battery in which lithium metal is precipitated.

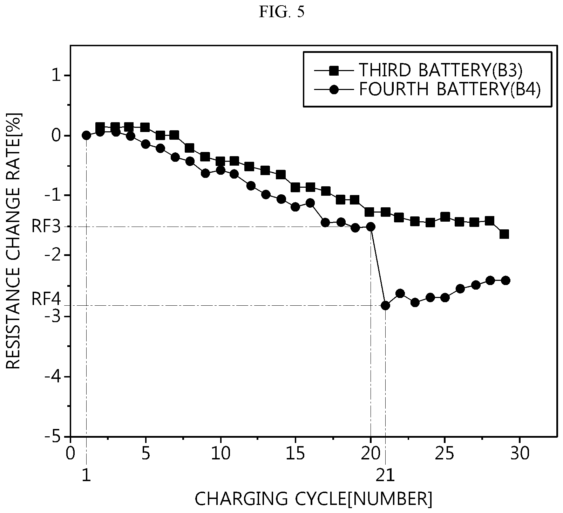

FIG. 5 is a diagram schematically showing a resistance change rate of a third battery B3 and a fourth battery B4 according to an embodiment of the present disclosure. Specifically, the third battery B3 is a normal battery in which lithium metal has not been precipitated, and the fourth battery B4 is a defective battery in which lithium metal has been precipitated from the 21st charging cycle. For example, the third battery B3 and the fourth battery B4 are the same type of battery, but in order to determine the change in resistance change rate when lithium metal is precipitated, lithium metal is precipitated on the negative electrode of the fourth battery B4 from the 21st charging cycle.

Also, the embodiment of FIG. 5 shows the 3 second resistance change rate of the third battery B3 and the fourth battery B4. In other words, the time during which charging of the third battery B3 and the fourth battery B4 is blocked is set to 3 seconds, the resistance value of the third battery B3 and the fourth battery B4 is calculated based on the voltage change for 3 seconds, and the resistance change rate is calculated based on the calculated resistance value.

In the example of FIG. 5, the difference in resistance change rate corresponding to the successive charging cycle of the third battery B3 is not greater than the threshold value (1%). Therefore, the control unit 120 may diagnose the third battery B3 as a normal battery in which lithium metal is not precipitated. On the other hand, because the difference (RF3 - RF4) in resistance change rate between the 20th and 21st charging cycles of the fourth battery B4 is greater than the threshold value (1%), the control unit 120 may diagnose the fourth battery B4 as an abnormal battery in which lithium metal is precipitated.

In another embodiment, the control unit 120 may be configured to diagnose that lithium metal is precipitated in the battery if the ratio of the resistance difference to the BOL resistance value calculated in the first charging cycle of the battery is greater than or equal to a preset threshold value.

For example, as in the previous embodiment, assume that the BOL resistance value is R0, the battery resistance value calculated at the time point t1 is R1, and the battery resistance value calculated at the time point t2 (time point successive to the time point 11) is R2. The control unit 120 may calculate the resistance difference between the time point t2 and the time point t1 as "R1 - R2". Also, the control unit 120 may calculate the ratio of the resistance difference to the BOL resistance value according to the formula "(R1 - R2) ÷ R0 × 100". Also, if the calculated value is greater than or equal to the threshold value, the control unit 120 may diagnose that lithium metal is precipitated in the battery.

The rapid charging control apparatus 100 according to an embodiment of the present disclosure has the advantage of being able to diagnose the state of the battery in real time during the rapid charging process, based on the resistance value with the corresponding charging C-RATE. In particular, the state of the battery may be diagnosed by not simply considering the resistance difference between two successful charging cycles, but also considering the BOL resistance of the battery. Therefore, there is an advantage that the state of the battery may be accurately diagnosed in real time based on the initial resistance (BOL resistance) of the battery, the resistance value of the previous charging cycle, and the resistance value of the current charging cycle.

Below, an embodiment in which a SOC section is set for each charging C-RATE will be described.

The charging profile may be set to represent the corresponding relationship between the charging C-RATE and the SOC corresponding to a maximum point or an inflection point of the resistance profile preset to correspond to the charging C-RATE.

Here, the resistance profile may be set to represent the corresponding relationship between the resistance value corresponding to the charging C-RATE and the SOC. The corresponding relationship between the resistance value and the SOC of the battery may vary depending on the charging C-RATE. Therefore, preferably, the resistance profile may be provided for each charging C-RATE. For example, the resistance profile may be expressed as an X-Y graph where the X-axis is set to SOC and the Y-axis is set to resistance value.

Specifically, the corresponding relationship between the charging C-RATE and the SOC may be set depending on the presence or absence of the maximum point or the inflection point of the resistance profile.

More specifically, the maximum point refers to a point corresponding to the local maximum differentiable in the resistance profile. In other words, the maximum point is a point where the instantaneous change rate of the resistance to SOC is 0, and the instantaneous change rate of the resistance to SOC may change from positive to negative around the maximum point.

For example, the charging profile may be set so that if a maximum point exists in the resistance profile, the SOC corresponding to the maximum point corresponds to the charging C-RATE.

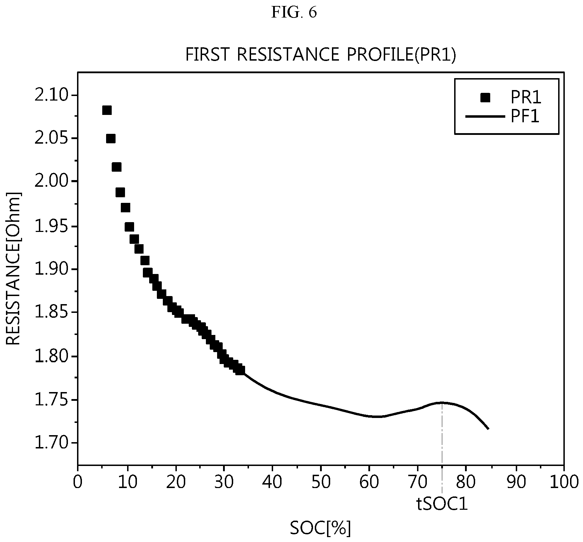

FIG. 6 is a diagram schematically showing a first resistance profile PR1 according to an embodiment of the present disclosure.

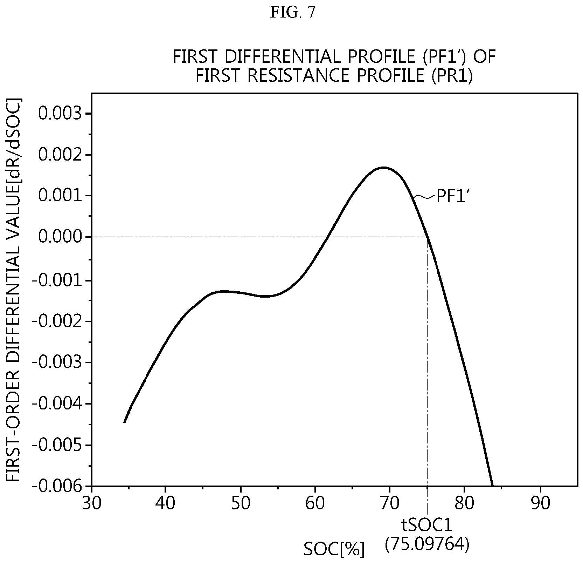

FIG. 7 is a diagram schematically showing a first differential profile PF1' of the first resistance profile PR1 according to an embodiment of the present disclosure.

Specifically, the first resistance profile PR1 is a profile representing the corresponding relationship between SOC and resistance obtained while the battery is charged at a charging C-RATE of 0.75 C. The first differential profile PF1' of the first resistance profile PR1 is the first-order differential profile of the first fitting profile PF1, which is obtained by performing polynomial curve fitting to the first resistance profile PR1.

Specifically, by differentiating the first resistance profile PR1 according to the embodiment of FIG. 6, the first differential profile PF1' according to the embodiment of FIG. 7 may be derived.

In the embodiment of FIG. 7, considering the first-order differential value of the first differential profile PF1', it can be seen that there is a maximum point in the first resistance profile PR1. The SOC of the maximum point of the first resistance profile PR1 is tSOC1 (75.09764%). For example, the upper limit of the SOC section corresponding to a charging C-RATE of 0.75 C may be set to 75% (value obtained by rounding off 75.09764% to the decimal place).

As another example, the charging profile may be set so that if there is no maximum point in the resistance profile and an inflection point exists, the SOC corresponding to the inflection point corresponds to the charging C-RATE.

In general, as the charging C-RATE increases, the overvoltage within the battery increases, and the resistance profile may change differently accordingly. In this case, there may not be a maximum point in the resistance profile for the battery. Therefore, if the upper limit of the SOC section corresponding to the charging C-RATE is set in the charging profile based on the maximum point, the battery may be charged rapidly due to an incorrectly set SOC section, which may cause lithium metal to precipitate on the negative electrode of the battery. Therefore, if there is no maximum point in the resistance profile, the upper limit of the SOC section corresponding to the charging C-RATE may be set depending on the presence or absence of the inflection point.

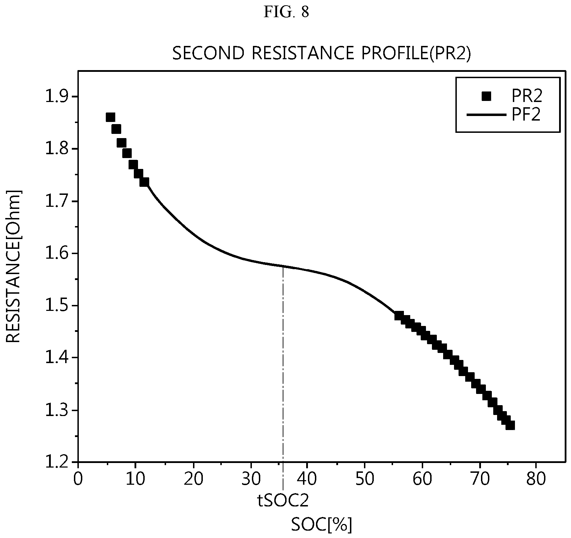

FIG. 8 is a diagram schematically showing a second resistance profile PR2 according to an embodiment of the present disclosure.

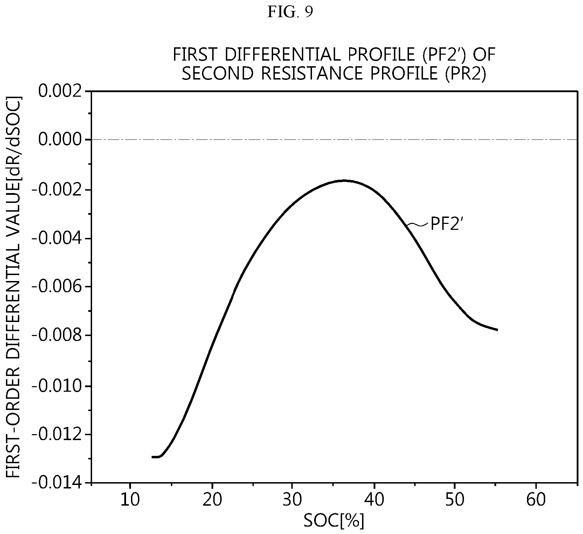

FIG. 9 is a diagram schematically showing a first differential profile PF2' of the second resistance profile PR2 according to an embodiment of the present disclosure.

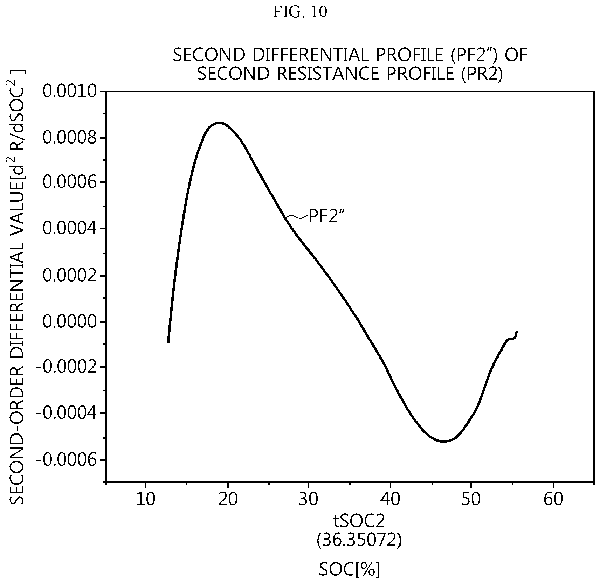

FIG. 10 is a diagram schematically showing a second differential profile PF2" of the second resistance profile PR2 according to an embodiment of the present disclosure.

Specifically, the second resistance profile PR2 is a profile representing the corresponding relationship between SOC and resistance obtained while charging the battery at a charging C-RATE of 2 C. The first differential profile PF2' of the second resistance profile PR2 is the first-order differential profile of the second fitting profile PF2, which is obtained by performing polynomial curve fitting to the second resistance profile PR2. Also, the second differential profile PF2" of the second resistance profile PR2 is the second-order differential profile of the second fitting profile PF2. In other words, the second differential profile PF2" of the second resistance profile PR2 is a profile obtained by differentiating the first differential profile PF2' of the second resistance profile PR2 again.

Specifically, by differentiating the second resistance profile PR2 according to the embodiment of FIG. 8, the first differential profile PF2' according to the embodiment of FIG. 9 may be derived. Also, by differentiating the first differential profile PF2' according to the embodiment of FIG. 9, the second differential profile PF2" according to the embodiment of FIG. 10 may be derived.

In the embodiment of FIG. 9, considering the first-order differential value of the first differential profile PF2', it can be seen that there is no maximum point in the first resistance profile PR1. However, in the embodiment of FIG. 10, considering the second-order differential value of the second differential profile PF2", it can be seen that an inflection point exists in the first resistance profile PR1. The SOC of the inflection point of the first resistance profile PR1 is tSOC2 (36.35072%). For example, the upper limit of the SOC section corresponding to a charging C-RATE of 2 C may be set to 36% (value obtained by rounding off 36.35072% to the decimal place).

For example, it is assumed that the charging C-RATE included in the charging profile is 2 C, 0.75 C, and 0.5 C, and the battery is charged at SOC 8% to 80%. In addition, it is assumed that the upper limit of the SOC section corresponding to the charging C-RATE of 2 C is SOC 36%, the upper limit of the SOC section corresponding to the charging C-RATE of 0.75 C is SOC 75%, and the upper limit of the SOC section corresponding to the charging C-RATE of 0.5 Cis SOC 80%. The charging profile may be set so that the battery is charged at a charging C-RATE of 2 C from SOC 8% to 36%, at a charging C-RATE of 0.75 C from SOC 36% to 75%, and at a charging C-RATE of 0.5 C from SOC 75% to 80%.

The rapid charging control apparatus 100 according to an embodiment of the present disclosure may control rapid charging of the battery using a charging profile set to prevent lithium metal from being precipitated in the battery during the rapid charging process. Therefore, precipitate of lithium metal due to rapid charging may be effectively prevented.

Meanwhile, the charging profile may be configured so that as the charging C-RATE decreases, the SOC corresponding to the charging C-RATE increases.

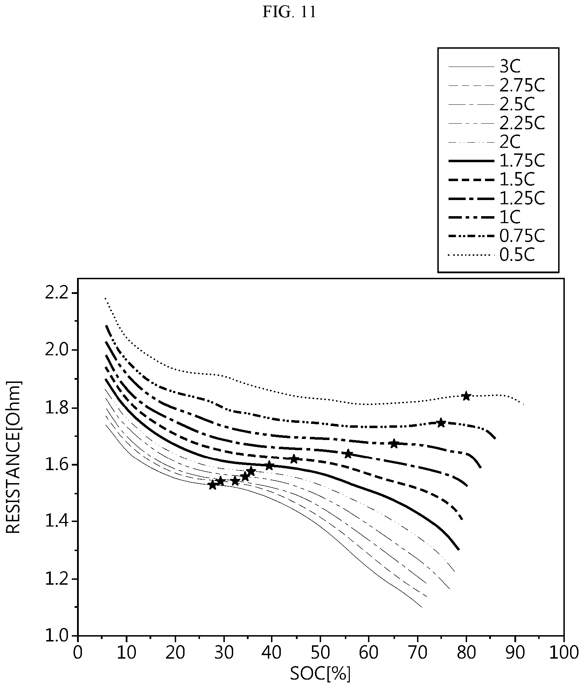

FIG. 11 is a diagram schematically showing a plurality of resistance profiles according to an embodiment of the present disclosure.

Specifically, the embodiment of FIG. 11 is a diagram showing a resistance profile corresponding to the charging C-RATE of 0.5 C, 0.75 C, 1 C, 1.25 C, 1.5 C, 1.75 C, 2 C, 2.25 C, 2.5 C, 2.75 C and 3 C, and the upper limit (marked with ★) of the SOC section.

Referring to FIG. 11, as the charging C-RATE increases, the upper limit of the SOC section corresponding to the charging C-RATE may decrease. Conversely, as the charging C-RATE decreases, the upper limit of the SOC section corresponding to charging C-RATE may increase.

In the embodiment of FIG. 11, the resistance profile for the charging C-RATE from 0.5 C to 3 C and the upper limit of the SOC section are shown in 0.25 C units, but the upper limit of the SOC section for more diverse charging C-RATE may be set in advance in the charging profile.

The rapid charging control apparatus 100 according to the present disclosure may be applied to a battery management system (BMS). That is, the BMS according to the present disclosure may include the rapid charging control apparatus 100 described above. In this configuration, at least some of components of the rapid charging control apparatus 100 may be implemented by supplementing or adding functions of the components included in a conventional BMS. For example, the measuring unit 110, the control unit 120 and the storage unit 130 of the rapid charging control apparatus 100 may be implemented as components of the BMS.

Additionally, the rapid charging control apparatus 100 according to the present disclosure may be provided in the battery pack. That is, the battery pack according to the present disclosure may include the above-described rapid charging control apparatus 100, and at least one battery cell. Additionally, the battery pack may further include electrical components (relays, fuses, etc.) and a case.

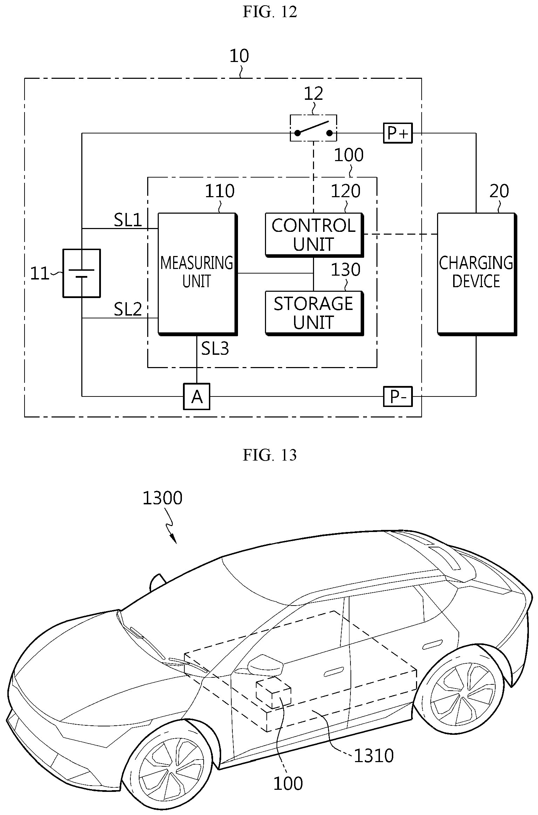

FIG. 12 is a diagram schematically showing an exemplary configuration of a battery pack 10 according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The relay 12 may be located in the charging and discharging path of the battery 11. Specifically, the relay 12 may be located in the main current path of the battery 11. For example, one end of the relay 12 may be electrically connected to the positive electrode terminal of the battery 11, and the other end of the relay 12 may be electrically connected to the positive electrode terminal P+ of the battery pack 10. Also, the charging and discharging path of the battery 11 may be opened or closed depending on the operation state of the relay 12.

The control unit 120 may control the operation state of the relay 12 to a turn-on state or a turn-off state. For example, the control unit 120 may control the operation state of the relay 12 to a turn-on state while charging the battery 11. Additionally, the control unit 120 may control the operation state of the relay 12 to a turn-off state while blocking charging of the battery 11.

The measuring unit 110 may be connected to a first sensing line SL1, a second sensing line SL2, and a third sensing line SL3. Specifically, the measuring unit 110 may be connected to the positive electrode terminal of the battery 11 through the first sensing line SL1, and may be connected to the negative electrode terminal of the battery 11 through the second sensing line SL2. The measuring unit 110 may measure the voltage of the battery 10 based on the voltage measured at each of the first sensing line SL1 and the second sensing line SL2.

Also, the measuring unit 110 may be connected to the current measurement unit A through the third sensing line SL3. For example, the current measurement unit A may be a current meter or a shunt resistance capable of measuring the charging current and discharging current of the battery 11.

One end of the charging device 20 may be connected to the positive electrode terminal P+ of the battery pack 10, and the other end may be connected to the negative electrode terminal P- of the battery pack 10. Accordingly, the positive electrode terminal of the battery 11, the positive electrode terminal P+ of the battery pack 10, the charging device 20, the negative electrode terminal P- of the battery pack 10, and the negative electrode terminal of the battery 11 may be electrically connected.

The charging device 20 may be connected to communicate with the control unit 120. For example, the charging device 20 and the control unit 120 may be connected to communicate using power line communication (PLC). The control unit 120 may transmit the determined charging C-RATE to the charging device 20, and the charging device 20 may output the charging current corresponding to the received charging C-RATE to the battery 11.

FIG. 13 is a diagram schematically showing an exemplary configuration of a vehicle 1300 according to still another embodiment of the present disclosure.

Referring to FIG. 13, the battery pack 1310 according to an embodiment of the present disclosure may be included in a vehicle 1300 such as an electric vehicle (EV) or a hybrid vehicle (HV). Additionally, the battery pack 1310 may drive the vehicle 1300 by supplying power to the motor through an inverter provided in the vehicle 1300. In addition, the battery pack 1310 may be equipped with the rapid charging control apparatus 100 to control rapid charging of the battery pack 1310.

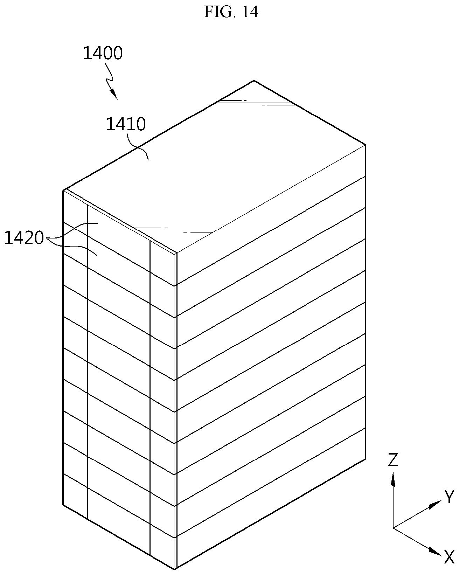

FIG. 14 is a diagram schematically showing an exemplary configuration of an energy storage system (ESS) 1400 according to still another embodiment of the present disclosure.

Referring to FIG. 14, the energy storage system 1400 includes a plurality of battery modules 1420 and a rack case 1410. The plurality of battery modules 1420 may be configured to be accommodated in the rack case 1410 in a vertically arranged form. For example, each of the plurality of battery modules 1420 may be equipped with the rapid charging control apparatus 100, and the rapid charging control apparatus 100 may control rapid charging of the corresponding battery module 1420.

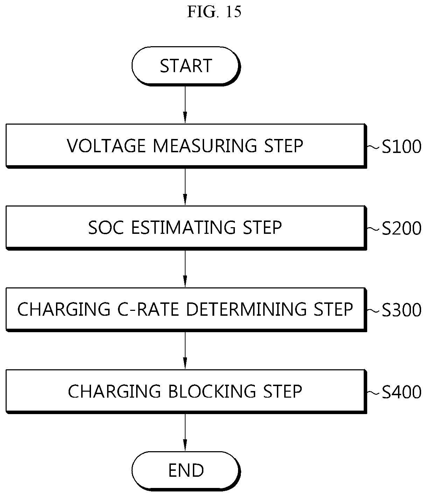

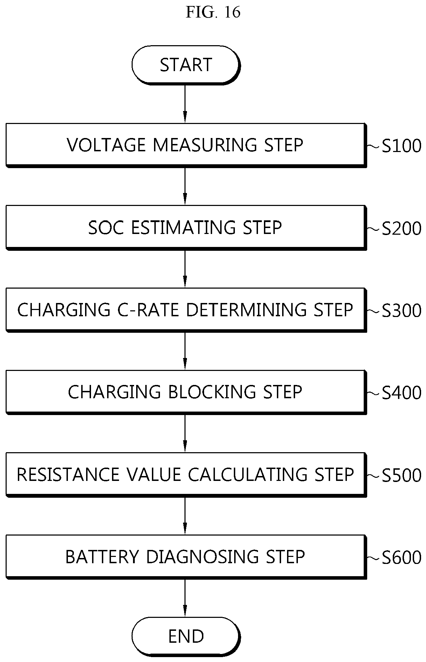

FIGS. 15 and 16 are diagrams schematically showing a rapid charging control method according to still another embodiment of the present disclosure.

Preferably, each step of the rapid charging control method may be performed by the rapid charging control apparatus 100. Hereinafter, for convenience of explanation, the content overlapping with the previously described content will be briefly described or omitted.

Referring to FIG. 15, the rapid charging control method may include a voltage measuring step (S100), a SOC estimating step (S200), a charging C-RATE determining step (S300), and a charging blocking step (S400).

The voltage measuring step (S100) is a step of measuring the voltage of the battery, and may be performed by the measuring unit 110.

For example, the measuring unit 110 may measure the voltage of the battery according to a preset voltage measurement cycle.

The SOC estimating step (S200) is a step of estimating the SOC of the battery based on the voltage of the battery, and may be performed by the control unit 120.

For example, the control unit 120 may estimate the SOC for the voltage measured in the voltage measuring step (S100) based on the SOC profile representing the corresponding relationship between voltage and SOC.

The charging C-RATE determining step (S300) is a step of determining the charging C-RATE corresponding to the estimated SOC, based on a charging profile preset to represent the corresponding relationship between SOC and charging C-RATE, and may be performed by the control unit 120.

For example, the control unit 120 may determine the SOC section to which the current SOC of the battery belongs from the charging profile and determine the charging C-RATE corresponding to the determined SOC section.

The charging blocking step (S400) is a step of blocking charging of the battery for a predetermined time when the charging C-RATE corresponding to the estimated SOC changes, and may be performed by the control unit 120.

For example, when the charging C-RATE corresponding to the estimated SOC changes, the control unit 120 may block battery charging for a predetermined time. That is, the control unit 120 may block battery charging for a predetermined time when the estimated SOC reaches the upper limit of the SOC section to which the estimated SOC currently belongs.

The rapid charging control method according to an embodiment of the present disclosure may control rapid charging of the battery to have a rest period for a predetermined time whenever the charging C-RATE is changed during the rapid charging process.

Referring to FIG. 16, the rapid charging control method may further include a resistance value calculating step (S500) and a battery diagnosing step (S600).

The resistance value calculating step (S500) is a step of calculating the resistance value of the battery based on the voltage change for a predetermined time after the charging blocking step (S400), and may be performed by the control unit 120.

For example, the control unit 120 may calculate the resistance value of the battery based on the voltage change of the battery during the time when charging of the battery is blocked by using Ohm's law.

In the embodiment of FIG. 3, the control unit 120 may calculate the resistance value of the battery by calculating the formula "(Vs - Vd) ÷ I1".

The battery diagnosing step (S600) is a step of diagnosing the state of the battery according to the calculated resistance value, and may be performed by the control unit 120.

In one embodiment, the control unit 120 may be configured to calculate a resistance change rate of the resistance value with respect to the BOL resistance value calculated in the first charging cycle of the battery. Additionally, the control unit 120 may be configured to diagnose that lithium metal is precipitated in the battery if the difference in resistance change rates calculated in the successive charging cycles is greater than or equal to a preset threshold value.

In another embodiment, the control unit 120 may be configured to diagnose that lithium metal is precipitated in the battery if the ratio of the resistance difference to the BOL resistance value calculated in the first charging cycle of the battery is greater than or equal to a preset threshold value.

In other words, the rapid charging control method according to an embodiment of the present disclosure has the advantage of being able to diagnose the state of the battery in real time during the rapid charging process, based on the resistance values with the same corresponding charging C-RATE.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
11: battery
12: relay
20: charging device
100: rapid charging control apparatus
110: measuring unit
120: control unit
130: storage unit
1300: vehicle
1310: battery pack
1400: energy storage system
1410: rack case
1420: battery module

## Claims

1. A rapid charging control apparatus, comprising:
a measuring unit configured to measure a voltage of a battery; and
a control unit configured to estimate a SOC of the battery based on the voltage of the battery, determine a charging C-RATE corresponding to the estimated SOC based on a charging profile preset to represent the corresponding relationship between SOC and charging C-RATE, and block charging of the battery for a predetermined time when the charging C-RATE corresponding to the estimated SOC changes.

2. The rapid charging control apparatus according to claim 1,
wherein the charging profile is configured to include a plurality of SOC sections where a corresponding charging C-RATE is set, and
wherein when the estimated SOC reaches an upper limit of a current SOC section to which the estimated SOC belongs as the estimated SOC increases, the control unit is configured to block charging of the battery for the predetermined time and change the charging C-RATE for the battery to a charging C-RATE corresponding to the next SOC section.

3. The rapid charging control apparatus according to claim 2,
wherein the control unit is configured to resume charging the battery at the changed charging C-RATE after the predetermined time has elapsed.

4. The rapid charging control apparatus according to claim 2,
wherein the charging C-RATE is set to decrease when the SOC section to which the estimated SOC belongs changes as the estimated SOC increases.

5. The rapid charging control apparatus according to claim 1,
wherein the control unit is configured to calculate a resistance value of the battery based on the voltage change during the predetermined time and diagnose a state of the battery according to the calculated resistance value.

6. The rapid charging control apparatus according to claim 5,
wherein the control unit is configured to calculate the resistance value whenever charging of the battery is blocked for the predetermined time in a plurality of charging cycles, and diagnose the state of the battery by comparing resistance values with the same corresponding charging C-RATE.

7. The rapid charging control apparatus according to claim 6,
wherein the control unit is configured to diagnose that lithium metal is precipitated in the battery based on resistance values calculated in successive charging cycles among the resistance values with the same corresponding charging C-RATE.

8. The rapid charging control apparatus according to claim 7,
wherein the control unit is configured to calculate a resistance change rate of the resistance value with respect to a BOL resistance value calculated in a first charging cycle of the battery, and diagnose that lithium metal is precipitated in the battery when a difference between the resistance change rates calculated in the successive charging cycles is greater than or equal to a preset threshold value.

9. The rapid charging control apparatus according to claim 7,
wherein the control unit is configured to diagnose that lithium metal is precipitated in the battery when a ratio of the resistance difference to the BOL resistance value calculated in the first charging cycle of the battery is greater than or equal to a preset threshold value.

10. The rapid charging control apparatus according to claim 1,
wherein the charging profile is set to represent the corresponding relationship between the charging C-RATE and SOC corresponding to a maximum point or an inflection point of a resistance profile preset to correspond to the charging C-RATE, and
wherein the resistance profile is set to represent the corresponding relationship between a resistance value corresponding to the charging C-RATE and the SOC.

11. The rapid charging control apparatus according to claim 10,
wherein when the maximum point exists in the resistance profile, the charging profile is set so that the SOC corresponding to the maximum point corresponds to the charging C-RATE, and
wherein when the maximum point does not exist in the resistance profile and the inflection point exists, the charging profile is set so that the SOC corresponding to the inflection point corresponds to the charging C-RATE.

12. The rapid charging control apparatus according to claim 11,
wherein the charging profile is configured so that the SOC corresponding to the charging C-RATE increases as the charging C-RATE decreases.

13. A battery pack, comprising the rapid charging control apparatus according to any one of claims 1 to 12.

14. A rapid charging control method, comprising:
a voltage measuring step of measuring a voltage of a battery;
a SOC estimating step of estimating a SOC of the battery based on the voltage of the battery;
a charging C-RATE determining step of determining a charging C-RATE corresponding to the estimated SOC based on a charging profile preset to represent the corresponding relationship between SOC and charging C-RATE; and
a charging blocking step of blocking charging of the battery for a predetermined time when the charging C-RATE corresponding to the estimated SOC changes.

15. The rapid charging control method according to claim 14, further comprising:
a resistance value calculating step of calculating a resistance value of the battery based on the voltage change during the predetermined time, after the charging blocking step; and
a battery diagnosing step of diagnosing a state of the battery according to the calculated resistance value.
